# EUROPEAN PATENT SPECIFICATION

(11) **EP 3 751 294 B1**
(45) Date of publication and mention of the grant of the patent: **09.08.2023**
(21) Application number: 19180186.9
(22) Date of filing: 14.06.2019
(51) Int. Cl.: G01R 13/02, H04Q 9/04

(54) **DEVICE AND METHOD FOR SYNCHRONIZATION OF SENSORS**
VORRICHTUNG UND VERFAHREN ZUR SYNCHRONISATION VON SENSOREN
DISPOSITIF ET PROCÉDÉ DE SYNCHRONISATION DE CAPTEURS

(43) Date of publication of application: 16.12.2020
(73) Proprietor: Rohde & Schwarz GmbH & Co. KG, 81671 München (DE)
(72) Inventor: Güzelarslan, Baris, 85521 Ottobrunn (DE)
(74) Representative: Rupp, Christian

(56) References cited:
- EP-A1- 3 438 776
- GB-A- 2 320 392
- US-A1- 2010 007 476
- US-A1- 2016 323 565
- US-B2- 10 109 061
- BRITO DARLAN N ET AL: "Temporal synchronization in mobile sensor networks using image sequence analysis", MACHINE VISION AND APPLICATIONS, SPRINGER VERLAG, DE, vol. 25, no. 4, 27 March 2014 (2014-03-27) , pages 1067-1076, XP035368587, ISSN: 0932-8092, DOI: 10.1007/S00138-014-0605-6 [retrieved on 2014-03-27]

## Description

The invention relates to synchronization of sensors, in particular based on image registration. More specifically, the synchronization is based on aligning of graphic representations of signals obtained by at least two sensors.

It is a typical scenario that a user records signals using different sensors and then wants to merge the obtained signals. The sensors are for example located in a single device or are distributed across multiple devices. A measurement device that comprises a sensor e.g. is a signal analyzer or spectrum analyzer.

The recorded signals are merged based on time-frequency windows of detections, which requires time-consuming synchronization of the used sensors. Also, a separate synchronization signal for synchronizing the sensors is required. US 7,624,294 B2 e.g. discloses how to synchronize measurement devices using additional trigger signals. These approaches however result in high manufacturing and operating costs of measurement devices. US 10 109 061 B2 discloses the synchronisation between signals from a motion sensor and signals from a video camera using graphical representations of the respective signals.

The object of the invention is to provide a device for synchronization of at least two sensors with reduced manufacturing and operating costs. Moreover, the object is to provide an according method and computer program.

The object is solved by the features of the first independent claim for the device and by the features of the second independent claim for the method. Further, it is solved by the features of an associated computer program claim. The dependent claims contain further developments.

The inventive device for synchronization of at least two sensors allows for cost effective manufacturing and operating of the device, wherein synchronization of the sensors is enabled without using an additional synchronization signal.

In particular, the first sensor and the second sensor obtain signals at different locations.

In particular, the obtaining of the signals with the sensors is not time synchronized based on a synchronization signal. That is, the sensors are not time-synchronized based on an additional signal. Synchronization is obtained based on the graphic representations of the first and second signal.

In particular, the first sensor and the second sensor are located in separate physical units, which together form the device. To this end, the separate units can be connected by means of a communication link. The device is further configured to determine a time offset between the first signal and the second signal based on the first graphic representation, the second graphic representation and the combined graphic representation, and to synchronize the first sensor and the second sensor based on the time offset.

This allows for synchronization of the sensors based on the time offset. As the time offset is generated based on the graphic representations, synchronization can be performed without an additional synchronization signal.

In particular, the time offset is also determined based on a parameter of the transformation. In particular, the synchronization is time-synchronization. In particular, the time synchronization is obtained based on a visual content of the first graphic representation, the second graphic representation and the combined graphic representation.

This is beneficial as the time synchronization can be obtained without using an additional synchronization signal or mechanism.

In particular, the time offset is determined based on a time stamp which relates to an image line of at least one of the graphic representations (i.e. the first graphic representation, the second graphic representation and/or the combined graphic representation).

Advantageously and preferably, the device is further configured to generate a synchronized signal based on the first signal, the second signal and the time offset. This is beneficial, as a more versatile device is provided, which can not only synchronize the sensors, but also generate and output a synchronized signal.

In particular, the synchronized signal is a time-synchronized signal. In particular, the synchronized signal is called a fused signal, e.g. obtained from signal fusion.

The first signal is a radio frequency, RF, signal, and wherein the second signal is a RF signal. This is beneficial, as the inventive device can be used in a RF measurement device such as a spectrum analyzer. In particular, the first sensor and/or the second sensor is a RF sensor, e.g. an antenna. Advantageously and preferably, the device is further configured to align the second graphic representation and the first graphic representation based on an image registration algorithm, in particular based on an intensity-based and/or feature-based image registration algorithm and/or a neural network. This allows for an efficient and effective way of aligning the graphic representations.

The first graphic representation and the second graphic representation and the combined graphic representation are frequency over time diagrams.

This is beneficial, because the inventive device can be used in a device which generates or processes a frequency over time diagram, a spectrum, or a water fall spectrum (e.g. a spectrum analyzer). As these kind of graphic representations typically contain a lot of parallel patterns, they can be transformed and aligned very efficiently. In particular, the first graphic representation and/or the second graphic representation illustrates a sampled signal including signal values and time stamps of the signal values.

Advantageously and preferably, the transformation includes at least one of the following: rotation, scaling, translation, linear transformation, affine transformation, rigid transformation, non-rigid transformation, Euclidean transformation, similarity transformation, projective transformation, transformation based on a radial basis function, transformation based on a physical continuum model, transformation based on a large deformation model. This allows for using various efficient and effective ways of transforming the graphic representations.

Advantageously and preferably, the device is further configured to apply a plausibility check to the combined graphic representation. This ensures that an operating result of the inventive device is reliable, as a further check is applied.

In particular, applying the plausibility check to the combined graphic representation includes determining, whether all sensors receive common data, or a subset of common data; and/or to determine, whether the received signals are theoretically possible; and/or to determine, whether one of the sensors or the device is malfunctioning.

Advantageously and preferably, the device is further configured to output, post process, and/or store the combined graphic representation. This allows for a versatile use of the device.

In particular, the combined graphic representation can be graphically output. In particular, post processing includes magnitude alignment. In particular, the combined graphic representation can be stored on a storage medium, e.g. for post processing.

An inventive method for synchronization of at least two sensors comprises the steps of generating, by a device, a first graphic representation of a first signal obtained by a first sensor of the device; generating, by the device, a second graphic representation of a second signal obtained by a second sensor of the device; applying, by the device, a transformation to the second graphic representation to align the second graphic representation and the first graphic representation and to obtain a combined graphic representation.

The method further comprises determining, by the device, a time offset between the first signal and the second signal based on the first graphic representation, the second graphic representation and the combined graphic representation, and synchronizing, by the device, the first sensor and the second sensor based on the time offset. Advantageously and preferably, the method further comprises generating, by the device, a synchronized signal based on the first signal, the second signal and the time offset.

The first signal is a radio frequency, RF, signal, and the second signal is a RF signal. Advantageously and preferably, the method further comprises aligning the second graphic representation and the first graphic representation based on an image registration algorithm, in particular based on an intensity-based and/or feature-based image registration algorithm and/or a neural network.

The first graphic representation and the second graphic representation and the combined graphic representation are frequency over time diagrams.

Advantageously and preferably, the transformation includes at least one of the following: rotation, scaling, translation, linear transformation, affine transformation, rigid transformation, non-rigid transformation, Euclidean transformation, similarity transformation, projective transformation, transformation based on a radial basis function, transformation based on a physical continuum model, transformation based on a large deformation model.

Advantageously and preferably, the method further comprises applying a plausibility check to the combined graphic representation. Advantageously and preferably, the method further comprises outputting, post processing, and/or storing the combined graphic representation.

The inventive method comprises the same advantages as the inventive device.

An inventive computer program comprises program code for performing the previously described method, when the computer program runs on a computer or a digital signal processor. The inventive computer program comprises the same advantages as the inventive device.

An exemplary embodiment of the invention is now further explained with respect to the drawings by way of examples only, in which
- FIG. 1: shows a schematic view of a device according to an embodiment of the present invention;
- FIG. 2: shows a schematic view of a device according to an embodiment of the present invention in more detail;
- FIG. 3: shows a schematic view of an operating scenario of the present invention;
- FIG. 4: shows transformations which can be implemented by the device according to the present invention;
- FIG. 5: shows a schematic view of image registration;
- FIG. 6: shows another schematic view of image registration; and
- FIG. 7: shows a schematic view of a a non-claimed method.

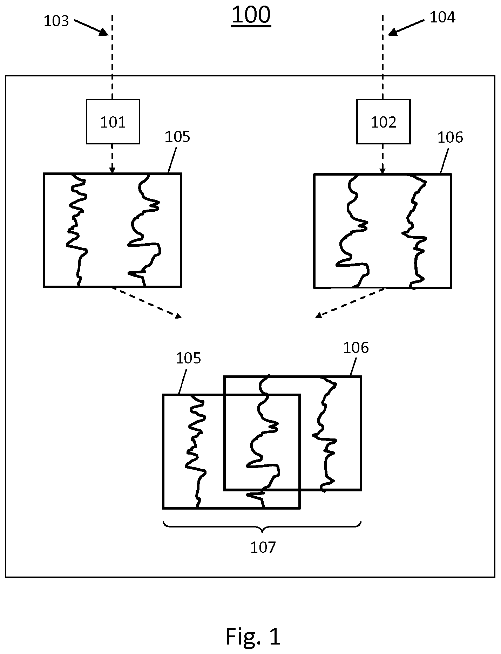

FIG. 1 shows a device 100 for synchronization of at least two sensors 101, 102. The device 100 e.g. is a measurement device such as a signal analyzer or a spectrum analyzer. The device 100 includes a first sensor 101 and a second sensor 102. A first signal 103 is obtained by the first sensor 101, and a second signal 104 is obtained by the second sensor 102. The device 100 is further configured to generate a first graphic representation 105 of the first signal 103, and a second graphic representation 106 of the second signal 104. The device 100 is further configured to apply a transformation to the second graphic representation 106 to align the second graphic representation 106 and the first graphic representation 105 and to obtain a combined graphic representation 107.

In particular, the combined graphic representation 107 is obtained by matching patterns of the first graphic representation 105 with corresponding patterns (which are similar or identical) of the second graphic representation 106. As shown in FIG. 1, the right pattern of the first graphic representation 105 matches the left pattern of the second graphic representation 106. A transformation is applied to the second graphic representation 106, to align (i.e. to overlay) said patterns and obtain the combined graphic representation 107.

Based on the first graphic representation 105, the second graphic representation 106 and the combined graphic representation 107, the device 100 can synchronize the first sensor 101 and the second sensor 102.

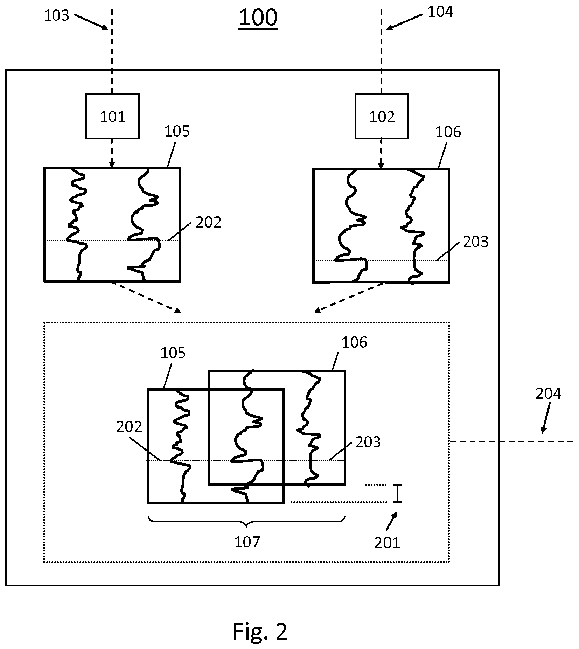

FIG. 2 shows the device 100 in more detail. The device 100 described in FIG. 2 includes all features and functionality of the device 100 of FIG. 1. Therefore, corresponding features are labeled by identical reference signs.

As shown in FIG. 2, the device 100 is further configured to determine a time offset 201 between the first signal 103 and the second signal 104. The determination is based on the first graphic representation 105, the second graphic representation 106 and the combined graphic representation 107. Once the time offset is determined, the device 100 synchronizes the first sensor 101 and the second sensor 102 based on the time offset 201.

As illustrated in FIG. 2, each image line of a graphic representation can be associated with a time stamp. In the first graphic representation 105, a first image line with a first time stamp 202 is shown, and in the second graphic representation 106, a second image line with a second time stamp 203 is shown. The first and the second image line at least partially have a common pattern. That is, the time offset 201 e.g. can be calculated by aligning the graphic representations and by subtracting the time stamp 203 from the time stamp 202 (or by subtracting the time stamp 202 from the time stamp 203, depending on a use case).

As it is further illustrated in FIG. 2, based on the first signal 103, the second signal 104 and the time offset 201, the device 100 optionally can generate a synchronized signal 204 and output it. The synchronized signal may also be called fused signal.

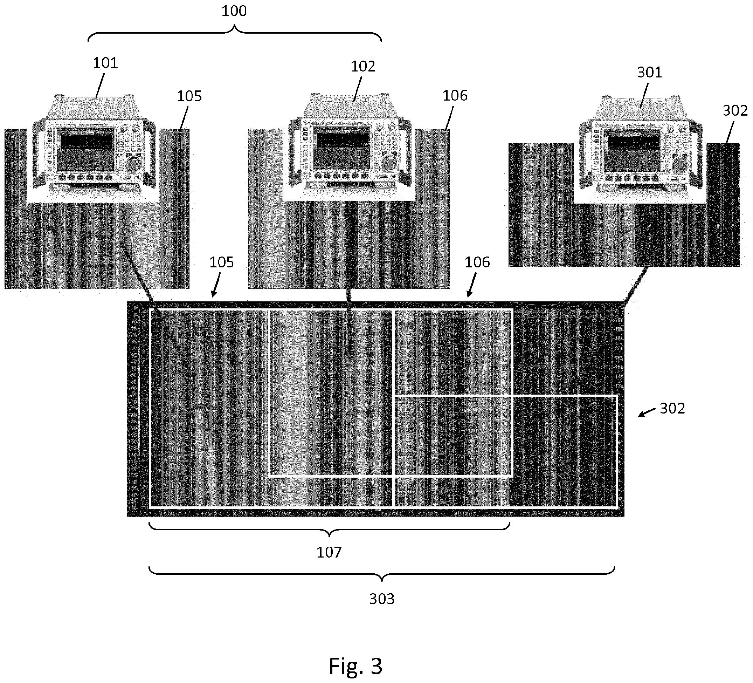

FIG. 3 shows an operating scenario in which the device 100 is used. In the example of FIG. 3, the device 100 is formed by at least two measurement devices. In particular, these measurement devices can be signal and/or spectrum analyzers. The first sensor 101 is comprised by the first measurement device and the second sensor 102 is comprised by the second measurement device.

Optionally, also a third measurement device can be comprised by the device 100. A third sensor 301 (which obtains a third signal) is included in the third measurement device. The device 100 can optionally be configured to generate a third graphic representation 302 based on the third signal. The third graphic representation 302 can then also be transformed and included in a combined graphic representation 303 (which also comprises the combined graphic representation 107) and can be used for synchronization of the three sensors 101, 102, 301, and/or for calculating the time offset 201.

As it is illustrated in FIG. 3, the first graphic representation 105 and/or the second graphic representation 106 and/or the combined graphic representation 107 or 303 is a frequency over time diagram. (this is also the case for the device 100 of FIG. 1 or FIG. 2). These kinds of representations are in particular obtained, if the first signal 103 is a RF signal, and/or if the second signal 104 is a RF signal.

To allow for communication of the several sensors 101, 102, 301 of the device 100, which are located in separate measurement devices, the sensors and the measurement devices can be connected using a communication link.

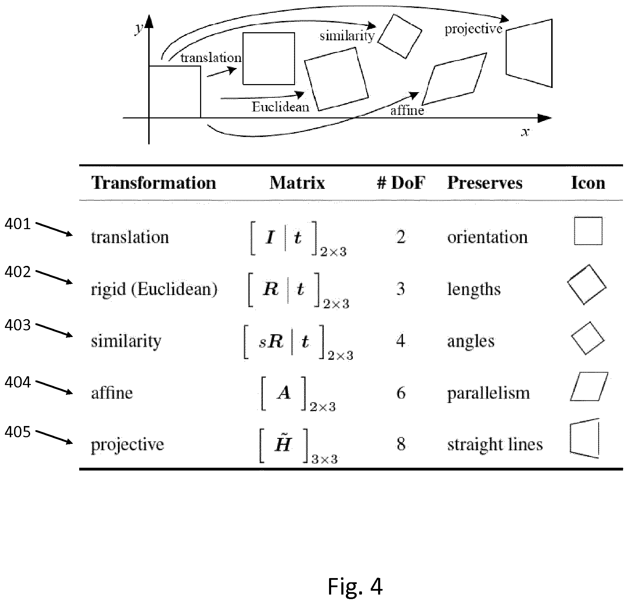

FIG. 4 shows example transformations which can be implemented by the device 100 according to any one of FIG. 1 to 3 above. To align the second graphic representation 106 with the first graphic representation 105, a translation 401, a rigid / Euclidean transformation 402, a similarity transformation 403, an affine transformation 404, or a projective transformation 405 can be used. The device 100 is however not limited to these translations, that is, also a rotation, a scaling, a linear transformation, a non-rigid transformation, a transformation based on a radial basis function, a transformation based on a physical continuum model, and/or a transformation based on a large deformation model can be used.

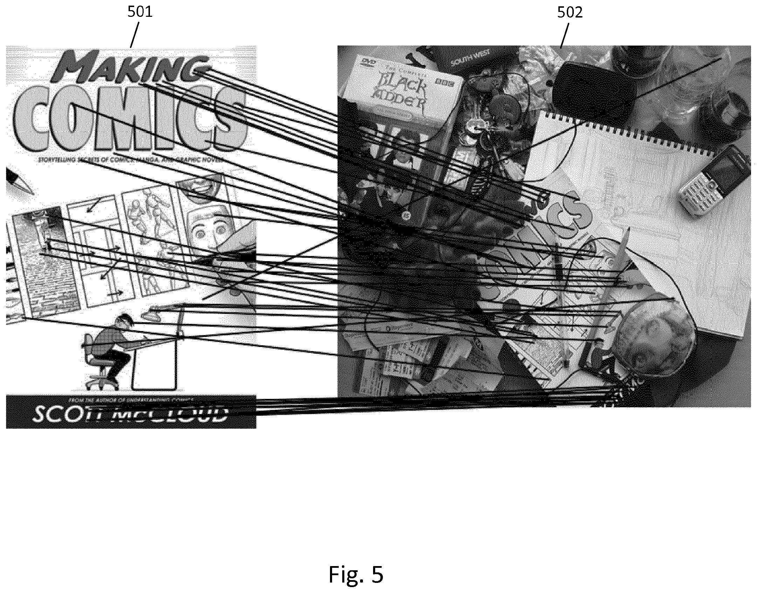

FIG. 5 shows a schematic example of image registration that can be implemented by the device 100. More specifically, aligning the second graphic representation 106 and the first graphic representation 105 can optionally be based on an intensity-based and/or feature-based image registration algorithm. Intensity-based methods compare intensity patterns in images via correlation metrics, while feature-based methods determine the correspondence between image features such as points, lines, and contours. In FIG. 5, the correspondence of features in the left graphic representation 501 and the right graphic representation 502is indicated by black lines.

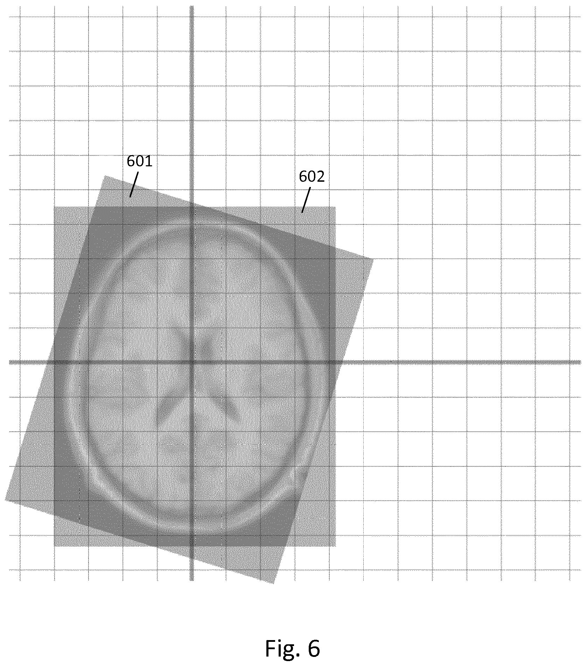

FIG. 6 shows another schematic example of image registration. Alignment algorithms the can be implemented by the device 100 can be mathematical functions or neuronal networks e.g. as used in medical imaging (e.g. computer tomography) for aligning pictures 601, 602 of different sectors (e.g. while a patient to be examined is slightly moving so that taken pictures cannot be superimposed without alignment).

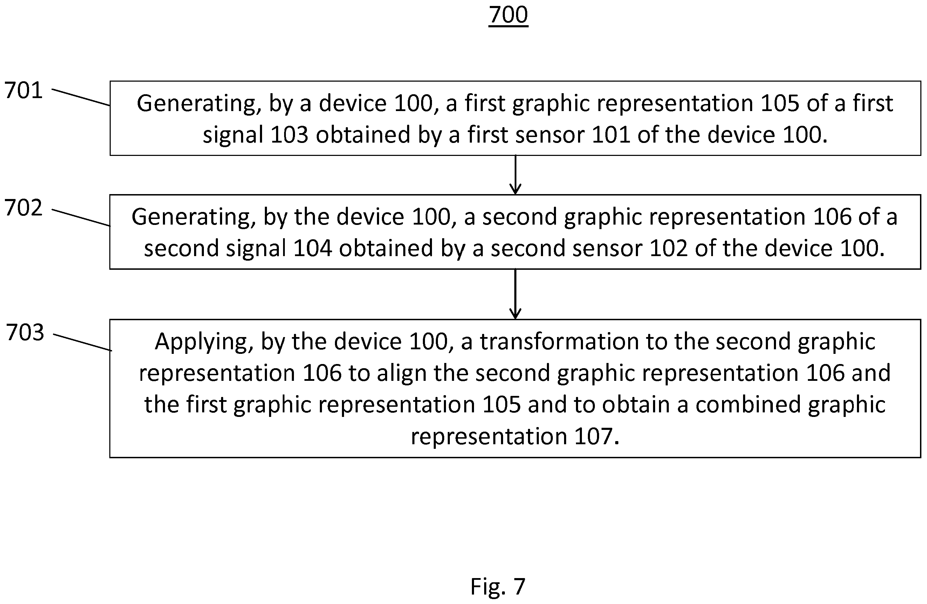

FIG. 7 schematically shows a method 700. The method is for synchronization of at least two sensors 101, 102 and comprises a first step of generating 701, by a device 100, a first graphic representation 105 of a first signal 103 obtained by a first sensor 101 of the device 100. The method 700 comprises a second step of generating 702, by the device 100, a second graphic representation 106 of a second signal 104 obtained by a second sensor 102 of the device 100. The method comprises a third step of applying 703, by the device 100, a transformation to the second graphic representation 106 to align the second graphic representation 106 and the first graphic representation 105 and to obtain a combined graphic representation 107. According to the present invention, graphic representations (resulting from data of different sensors) can be aligned graphically to a seamless picture and at the same time the graphical representations are timely synchronized via its visual content (not by using an additional synchronization signal or mechanism) in order to obtain a useful result. This is possible because timing information is contained in the (visual) representation of the signal. Each line of the graphical representation can have a time stamp obtained during sampling.

It is important to note that the inventive device and method very closely correspond. Therefore, all of the above said regarding the device is also applicable to the method. The scope of the present invention is defined by the claims.

## Claims

1. A device (100) for synchronization of at least two sensors (101, 102), wherein the device (100) is configured to:
- generate a first graphic representation (105) of a first signal (103) obtained by a first sensor (101) of the device (100);
- generate a second graphic representation (106) of a second signal (104) obtained by a second sensor (102) of the device (100);
- apply a transformation to the second graphic representation (106) to align the second graphic representation (106) and the first graphic representation (105) and to obtain a combined graphic representation (107) ;
- determine a time offset (201) between the first signal (103) and the second signal (104) based on the first graphic representation (105), the second graphic representation (106) and the combined graphic representation (107; and
- synchronize the first sensor (101) and the second sensor (102) based on the time offset (201);
wherein the first signal (103) is a radio frequency, RF, signal, and wherein the second signal (104) is a RF signal; and
wherein the first graphic representation (105) and the second graphic representation (106) and the combined graphic representation (107) are frequency over time diagrams.

2. The device (100) according to claim 1, further configured to generate a synchronized signal (204) based on the first signal (103), the second signal (104) and the time offset (201).

3. The device (100) according to any of the preceding claims, further configured to align the second graphic representation (106) and the first graphic representation (105) based on an image registration algorithm, in particular based on an intensity-based and/or feature-based image registration algorithm and/or a neural network.

4. The device (100) according to any of the preceding claims, wherein the transformation includes at least one of the following: rotation, scaling, translation (401), linear transformation, affine transformation (404), rigid transformation (402), non-rigid transformation, Euclidean transformation (402), similarity transformation (403), projective transformation (405), transformation based on a radial basis function, transformation based on a physical continuum model, transformation based on a large deformation model.

5. The device (100) according to any of the preceding claims, further configured to apply a plausibility check to the combined graphic representation (107).

6. The device (100) according to any of the preceding claims, further configured to output, post process, and/or store the combined graphic representation (107).

7. A method (700) for synchronization of at least two sensors (101, 102), wherein the method (700) comprises the steps of:
- generating (701), by a device (100), a first graphic representation (105) of a first signal (103) obtained by a first sensor (101) of the device (100);
- generating (702), by the device (100), a second graphic representation (106) of a second signal (104) obtained by a second sensor (102) of the device (100);
- applying (703), by the device (100), a transformation to the second graphic representation (106) to align the second graphic representation (106) and the first graphic representation (105) and to obtain a combined graphic representation (107);
- determining, by the device (100), a time offset (201) between the first signal (103) and the second signal (104) based on the first graphic representation (105), the second graphic representation (106) and the combined graphic representation (107); and
- synchronizing, by the device (100), the first sensor (101) and the second sensor (102) based on the time offset (201) ;
wherein the first signal (103) is a radio frequency, RF, signal, and wherein the second signal (104) is a RF signal; and
wherein the first graphic representation (105) and the second graphic representation (106) and the combined graphic representation (107) are frequency over time diagrams.

8. The method (700) according to claim 7, further comprising the step of generating, by the device (100), a synchronized signal (204) based on the first signal (103), the second signal (104) and the time offset (201).

9. The method (700) according to claim 7 or 8, further comprising the step of aligning the second graphic representation (106) and the first graphic representation (105) based on an image registration algorithm, in particular based on an intensity-based and/or feature-based image registration algorithm and/or a neural network.

10. A computer program with a program code for performing all steps of the method (700) according to any one of claims 7 to 9, when the computer program runs on a computer or a digital signal processor.

## Patentansprüche

1. Vorrichtung (100) für eine Synchronisation von mindestens zwei Sensoren (101, 102), wobei die Vorrichtung (100) konfiguriert ist, zum:
- Erzeugen einer ersten grafischen Darstellung (105) eines ersten Signals (103), das durch einen ersten Sensor (101) der Vorrichtung (100) erhalten wird;
- Erzeugen einer zweiten grafischen Darstellung (106) eines zweiten Signals (104), das durch einen zweiten Sensor (102) der Vorrichtung (100) erhalten wird;
- Anwenden einer Transformation auf die zweite grafische Darstellung (106), um die zweite grafische Darstellung (106) und die erste grafische Darstellung (105) auszurichten, und um eine kombinierte grafische Darstellung (107) zu erhalten;
- Bestimmen eines Zeitversatzes (201) zwischen dem ersten Signal (103) und dem zweiten Signal (104) basierend auf der ersten grafischen Darstellung (105), der zweiten grafischen Darstellung (106) und der kombinierten grafischen Darstellung (107); und
- Synchronisieren des ersten Sensors (101) und des zweiten Sensors (102) basierend auf dem Zeitversatz (201);
wobei das erste Signal (103) ein Hochfrequenz-Signal, HF-Signal, ist und wobei das zweite Signal (104) ein HF-Signal ist; und
wobei die erste grafische Darstellung (105) und die zweite grafische Darstellung (106) und die kombinierte grafische Darstellung (107) Frequenz-über-Zeitdiagramme sind.

2. Vorrichtung (100) nach Anspruch 1, die ferner konfiguriert ist, um ein synchronisiertes Signal (204) basierend auf dem ersten Signal (103), dem zweiten Signal (104) und dem Zeitversatz (201) zu erzeugen.

3. Vorrichtung (100) nach einem der vorstehenden Ansprüche, die ferner konfiguriert ist, um die zweite grafische Darstellung (106) und die erste grafische Darstellung (105) basierend auf einem Bildregistrierungsalgorithmus, insbesondere basierend auf einem intensitätsbasierten und/oder merkmalsbasierten Bildregistrierungsalgorithmus und/oder einem neuronalen Netzwerk auszurichten.

4. Vorrichtung (100) nach einem der vorstehenden Ansprüche, wobei die Transformation mindestens eines der Folgenden einschließt: Drehung, Skalieren, Translation (401), lineare Transformation, affine Transformation (404), starre Transformation (402), nicht-starre Transformation, euklidische Transformation (402), Ähnlichkeitstransformation (403), projektive Transformation (405), Transformation basierend auf einer radialen Basisfunktion, Transformation basierend auf einem physischen Kontinuummodell, Transformation basierend auf einem großen Verformungsmodell.

5. Vorrichtung (100) nach einem der vorstehenden Ansprüche, die ferner konfiguriert ist, um eine Plausibilitätsprüfung auf die kombinierte grafische Darstellung (107) anzuwenden.

6. Vorrichtung (100) nach einem der vorstehenden Ansprüche, die ferner konfiguriert ist, um die kombinierte Grafikdarstellung (107) auszugeben, nachzuverarbeiten und/oder zu speichern.

7. Verfahren (700) für die Synchronisation von mindestens zwei Sensoren (101, 102), wobei das Verfahren (700) die folgenden Schritte umfasst:
- Erzeugen (701), durch eine Vorrichtung (100), einer ersten grafischen Darstellung (105) eines ersten Signals (103), das durch einen ersten Sensor (101) der Vorrichtung (100) erhalten wird;
- Erzeugen (702), durch die Vorrichtung (100), einer zweiten grafischen Darstellung (106) eines zweiten Signals (104), das durch einen zweiten Sensor (102) der Vorrichtung (100) erhalten wird;
- Anwenden (703), durch die Vorrichtung (100) einer Transformation auf die zweite grafische Darstellung (106), um die zweite grafische Darstellung (106) und die erste grafische Darstellung (105) auszurichten, und um eine kombinierte grafische Darstellung (107) zu erhalten;
- Bestimmen, durch die Vorrichtung (100), eines Zeitversatzes (201) zwischen dem ersten Signal (103) und dem zweiten Signal (104) basierend auf der ersten grafischen Darstellung (105), der zweiten grafischen Darstellung (106) und der kombinierten grafischen Darstellung (107); und
- Synchronisieren, durch die Vorrichtung (100), des ersten Sensors (101) und des zweiten Sensors (102) basierend auf dem Zeitversatz (201);
wobei das erste Signal (103) ein Hochfrequenz-Signal, HF-Signal, ist und wobei das zweite Signal (104) ein HF-Signal ist; und
wobei die erste grafische Darstellung (105) und die zweite grafische Darstellung (106) und die kombinierte grafische Darstellung (107) Frequenz-über-Zeitdiagramme sind.

8. Verfahren (700) nach Anspruch 7, ferner umfassend den Schritt des Erzeugens, durch die Vorrichtung (100), eines synchronisierten Signals (204) basierend auf dem ersten Signal (103), dem zweiten Signal (104) und dem Zeitversatz (201).

9. Verfahren (700) nach Anspruch 7 oder 8, ferner umfassend den Schritt des Ausrichtens der zweiten grafischen Darstellung (106) und der ersten grafischen Darstellung (105) basierend auf einem Bildregistrierungsalgorithmus, insbesondere basierend auf einem intensitätsbasierten und/oder merkmalsbasierten Bildregistrierungsalgorithmus und/oder einem neuronalen Netzwerk.

10. Computerprogramm mit einem Programmcode zum Durchführen aller Schritte des Verfahrens (700) nach einem der Ansprüche 7 bis 9, wenn das Computerprogramm auf einem Computer oder einem Digitalsignalprozessor läuft.

## Revendications

1. Dispositif (100) pour la synchronisation d'au moins deux capteurs (101, 102), dans lequel le dispositif (100) est configuré pour :
- générer une première représentation graphique (105) d'un premier signal (103) obtenu par un premier capteur (101) du dispositif (100) ;
- générer une seconde représentation graphique (106) d'un second signal (104) obtenu par un second capteur (102) du dispositif (100) ;
- appliquer une transformation à la seconde représentation graphique (106) pour aligner la seconde représentation graphique (106) et la première représentation graphique (105) et pour obtenir une représentation graphique combinée (107) ;
- déterminer un décalage temporel (201) entre le premier signal (103) et le second signal (104) sur la base de la première représentation graphique (105), de la seconde représentation graphique (106) et de la représentation graphique combinée (107) ; et
- synchroniser le premier capteur (101) et le second capteur (102) sur la base du décalage temporel (201) ;
dans lequel le premier signal (103) est un signal radiofréquence, RF, et dans lequel le second signal (104) est un signal RF ; et
dans lequel la première représentation graphique (105) et la seconde représentation graphique (106) et la représentation graphique combinée (107) sont des diagrammes de fréquence dans le temps.

2. Dispositif (100) selon la revendication 1, configuré en outre pour générer un signal synchronisé (204) sur la base du premier signal (103), du second signal (104) et du décalage temporel (201).

3. Dispositif (100) selon l'une quelconque des revendications précédentes, configuré en outre pour aligner la seconde représentation graphique (106) et la première représentation graphique (105) sur la base d'un algorithme de recalage d'image, en particulier sur la base d'un algorithme de recalage d'image basé sur l'intensité et/ou basé sur les caractéristiques et/ou d'un réseau neuronal.

4. Dispositif (100) selon l'une quelconque des revendications précédentes, dans lequel la transformation comporte au moins l'un des éléments suivants :
rotation, mise à l'échelle, translation (401), transformation linéaire, transformation affine (404), transformation rigide (402), transformation non rigide, transformation euclidienne (402), transformation de similarité (403), transformation projective (405), transformation basée sur une fonction de base radiale,
transformation basée sur un modèle de continuum physique, transformation basée sur un modèle de déformations importantes.

5. Dispositif (100) selon l'une quelconque des revendications précédentes, configuré en outre pour appliquer une vérification de plausibilité à la représentation graphique combinée (107).

6. Dispositif (100) selon l'une quelconque des revendications précédentes, configuré en outre pour sortir, post-traiter et/ou stocker la représentation graphique combinée (107).

7. Procédé (700) pour la synchronisation d'au moins deux capteurs (101, 102), dans lequel le procédé (700) comprend les étapes consistant à :
- générer (701), par un dispositif (100), une première représentation graphique (105) d'un premier signal (103) obtenu par un premier capteur (101) du dispositif (100) ;
- générer (702), par le dispositif (100), une seconde représentation graphique (106) d'un second signal (104) obtenu par un second capteur (102) du dispositif (100) ;
- appliquer (703), par le dispositif (100), une transformation à la seconde représentation graphique (106) pour aligner la seconde représentation graphique (106) et la première représentation graphique (105) et pour obtenir une représentation graphique combinée (107) ;
- déterminer, par le dispositif (100), un décalage temporel (201) entre le premier signal (103) et le second signal (104) sur la base de la première représentation graphique (105), de la seconde représentation graphique (106) et de la représentation graphique combinée (107) ; et
- synchroniser, par le dispositif (100), le premier capteur (101) et le second capteur (102) sur la base du décalage temporel (201) ;
dans lequel le premier signal (103) est un signal radiofréquence, RF, et dans lequel le second signal (104) est un signal RF ; et
dans lequel la première représentation graphique (105) et la seconde représentation graphique (106) et la représentation graphique combinée (107) sont des diagrammes de fréquence dans le temps.

8. Procédé (700) selon la revendication 7, comprenant en outre l'étape consistant à générer, par le dispositif (100), un signal synchronisé (204) sur la base du premier signal (103), du second signal (104) et du décalage temporel (201).

9. Procédé (700) selon la revendication 7 ou 8, comprenant en outre l'étape d'alignement de la seconde représentation graphique (106) et de la première représentation graphique (105) sur la base d'un algorithme de recalage d'image, en particulier sur la base d'un algorithme de recalage d'image basé sur l'intensité et/ou basé sur les caractéristiques et/ou d'un réseau neuronal.

10. Programme informatique avec un code de programme pour réaliser toutes les étapes du procédé (700) selon l'une quelconque des revendications 7 à 9, lorsque le programme informatique s'exécute sur un ordinateur ou un processeur de signal numérique.
